**Europäisches Patentamt**

(19) **European Patent Office**

**Office européen des brevets**

(11) Numéro de publication: **0 083 621**
**B1**

(12) # FASCICULE DE BREVET EUROPEEN

(45) Date de publication du fascicule du brevet:
**02.05.85**

(51) Int. Cl.⁴: **H 01 L 39/12**

(21) Numéro de dépôt: **82902182.3**

(22) Date de dépôt: **21.07.82**

(86) Numéro de dépôt international:
**PCT/FR 82/00123**

(87) Numéro de publication internationale:
**WO 83/00410 (03.02.83** Gazette 83/4)

(54) **PROCEDE D'AUGMENTATION DE LA TEMPERATURE CRITIQUE DE SUPRACONDUCTION DANS LES SUPRACONDUCTEURS ORGANIQUES QUASI-UNIDIMENSIONNELS ET NOUVEAUX COMPOSES SUPRACONDUCTEURS AINSI OBTENUS.**

(30) Priorité: **22.07.81 FR 8114291**

(43) Date de publication de la demande:
**20.07.83 Bulletin 83/29**

(45) Mention de la délivrance du brevet:
**02.05.85 Bulletin 85/18**

(84) Etats contractants désignés:
**DE GB NL**

(56) Documents cités:
**LA Recherche, volume 11, no. 116, November 1980
(Paris, FR) D. Jerome "Les conducteurs organiques des matériaux d'avenir" pages 1334-1336
Comptes Rendus, séries A et B Sciences Mathématique & Physique, volume 291, no. 5, October 1980 (Paris, FR)
M. Ribault "Supraconductivité et absence d'anomalie de Kohn dans le conducteur organique quasi unidimensionnel: (THTSF) 2AsF6" pages 145-148**

(73) Titulaire: **CENTRE NATIONAL DE LA RECHERCHE SCIENTIFIQUE (C.N.R.S.), 15, Quai Anatole France, F-75700 Paris (FR)**

(72) Inventeur: **JEROME, Denis, 1bis, rue des Fonds, F-78350 Jouy en Josas (FR)**
Inventeur: **MORE, Claude, Groupe Scolaire, F-84110 Vaison la Romaine (FR)**
Inventeur: **ROGER, Guy-Roland, Centre Sud 1, Bât. B2, F-13380 Plan de Cuques (FR)**
Inventeur: **SORBIER, Jean-Pierre Nouveaux Chartreux, Dahlia II Bld. de la Fédération, F-13004 Marseille (FR)**
Inventeur: **DELRIEU, Jean-Marc, 29, rue de la Feverie, F-91190 Gif sur Yvette (FR)**
Inventeur: **RIBAULT, Michel, 7, rue Louis Scocard, F-91440 Bures sur Yvette (FR)**
Inventeur: **FABRE, Jean-Marc, 19, rue des Acacias, F-34000 Montpellier (FR)**
Inventeur: **FOURNEL, André, 34, chemin de la Tour La Valentine, F-13119 St. Savournin (FR)**
Inventeur: **GIRAL, Louis, Les Deux Ruisseaux 2, avenue du Père Soulas, F-34100 Montpellier (FR)**
Inventeur: **BEGHGAARD, Klaus, H.C. Oersted Institute Universtitetsparken 5, DK-2100 Copenhague (DK)**

(74) Mandataire: **Chereau, Pierre Louis et al, Novapat-Cabinet Chereau 107, Boulevard Péreire, F-75017 Paris (FR)**

## Description

La présente invention concerne les composés supraconducteurs et, plus particulièrement, un procédé d'augmentation de la température critique de supraconduction dans des composés supraconducteurs organiques quasi unidimensionnels et les composés supraconducteurs organiques ainsi obtenus.

Les propriétés de supraconductivité présentées par certains corps à très basses températures et observées pour la première fois, en l'occurrence sur le mercure, en 1911 par Kamerlingh-Onnes, se sont révélées récemment exister dans des composés organiques à base de carbone, d'hydrogène et de sélénium. Cette découverte, qui est à mettre à l'actif de l'équipe à laquelle appartiennent les titulaires du présent brevet, a fait l'objet d'une communication à l'Académie des sciences de Paris le 14 janvier 1980, publiée dans le «Journal de Physique-Lettres», tome 290, 1980, série B, pp. 27 à 30, dont le contenu ainsi que la bibliographie sont supposés intégrés ici pour référence.

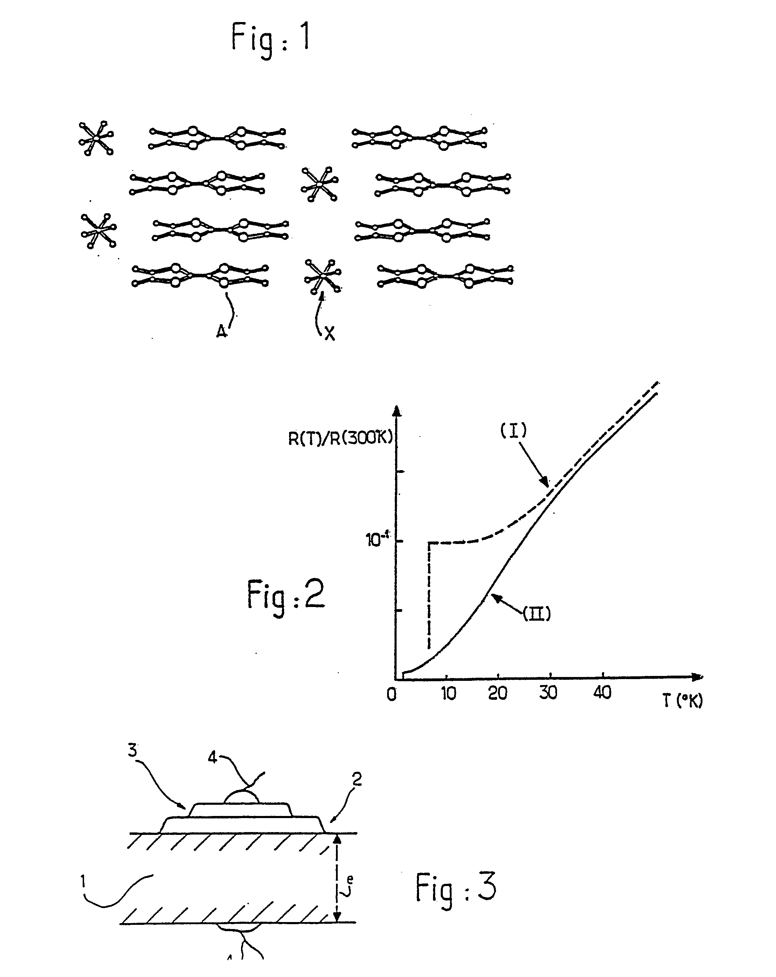

Cette publication se réfère à l'existence de supraconduction à très basse température (inférieure à 1 K) dans un conducteur organique $(TMTSF)_2X$ où $X = PF_6$, (di-$\Delta^{2,2'}$-bi-4 · 5-diméthyl-1,3-disélénolehexafluorophosphate) sous forme cristalline obtenu par une technique électrochimique à partir de constituants ultrapurs. Les composés $(TMTSF)_2X$ présentent, sous forme de monocristaux, une structure formée de chaînes de molécules organiques empilées, les ions X étant intercalés en colonnes entre les chaînes organiques, comme représenté sur la fig. 1 (où X représente $PF_6^-$). Cette structure présente un axe de forte conduction (verticale dans la représentation de la fig. 1) permettant de les qualifier de conducteurs moléculaires à propriété de transport quasi unidimensionnel (Q1D).

En étudiant les composés de cette classe, il a été constaté que, alors que la température critique au-dessous de laquelle s'établit un état de résistance nulle est de l'ordre de $T_{c3} = 1$ K, des signes précurseurs de supraconductivité, qualifiés de fluctuations supraconductrices, peuvent être observés dans une plage de températures s'étendant jusqu'à 40 K. La fig. 2 établit une comparaison entre les variations thermiques de la résistance d'un métal usuel supraconducteur (courbe I) (en l'occurrence le plomb) à basse température et celle d'un conducteur quasi unidimensionnel Q1D du type considéré (courbe II). La faible résistance et la forte dépendance en température du composé Q1D doivent être justement attribuées aux fluctuations supraconductrices susmentionnées.

On sait, par ailleurs, que de longues recherches ont permis de mettre au point des conducteurs intermétalliques, par exemple à base de Nb, Al, Ge, présentant une supraconductivité jusqu'à 23,2 K, c'est-à-dire avec une trop faible marge par rapport à la température de l'hydrogène liquide (20 K) pour envisager, pour leur utilisation, de substituer l'hydrogène liquide à l'hélium liquide, dont les nombreux inconvénients (tant de coût de fabrication que de stockage) sont bien connus des spécialistes des techniques cryogéniques.

Il existe donc, notamment en raison du vaste champ d'utilisations envisagées pour les supraconducteurs, un besoin très marqué de disposer de composés présentant des caractéristiques de supraconductivité à des températures supérieures à celle de l'hélium liquide et, mieux, supérieures à celle de l'hydrogène liquide.

La présente invention a précisément pour objet de proposer un procédé d'augmentation de la température critique de supraconduction dans les composés supraconducteurs organiques quasi unidimensionnels pour les rendre supraconducteurs bien au-delà de la température critique habituelle $T_{c3}$ pour ces composés.

La présente invention a pour autre objet de proposer de nouveaux composés du type considéré présentant des propriétés de supraconductibilité dans l'hydrogène liquide.

Pour ce faire, selon une caractéristique de la présente invention, le procédé comprend l'étape de réticuler les chaînes d'un tel composé conducteur moléculaire à propriété de transport quasi unidimensionnel avec des atomes étrangers d'au moins un corps potentiellement conducteur.

Selon une autre caractéristique de la présente invention, le procédé comprend l'étape de diffuser dans un composé $(TMTSF)_2X$, où X est choisi dans le groupe comprenant $ClO_4$, $PF_6$, $TaF_6$, $SbF_6$, $AsF_6$, $ReO_4$, $NbF_6$, des atomes de corps métalliques ou semi-conducteurs.

D'autres caractéristiques et avantages de la présente invention ressortiront de la description suivante faite en relation avec les dessins annexés sur lesquels:

la fig. 1 représente schématiquement une structure cristalline de conducteur moléculaire à propriété de transport quasi unidimensionnel, concerné par le procédé selon l'invention;

la fig. 2 est une courbe établissant la comparaison entre les variations thermiques de la résistance d'un métal supraconducteur et celle d'un tel conducteur quasi unidimensionnel;

la fig. 3 représente schématiquement un montage à jonction ou contact Schottky utilisé pour mettre en évidence les caractéristiques de supraconductivité d'un substrat $(TMTSF)_2X$;

la fig. 4 représente schématiquement, en macrocoupe, l'interface d'une telle jonction expliquant le procédé de l'invention;

la fig. 5 représente la courbe de variation de la résistance différentielle dynamique sous polarisation nulle d'une telle jonction $(TMTSF)_2PF_6/GaSb$ au niveau des zones S de l'interface sur la fig. 4;

la fig. 6 représente les variations de résistances différentielles d'une jonction similaire $(TMTSF)_2$-$ClO_4/GaSb$ en fonction de la polarisation et de l'application d'un rayonnement radiofréquence, et

la fig. 7 est une courbe similaire pour la même jonction montrant l'existence de propriétés supraconductrices jusqu'à 29 K.

Les titulaires ont démontré que les phénomènes de fluctuations supraconductrices constatés au-dessous de 40 K dans les conducteurs molécuai-

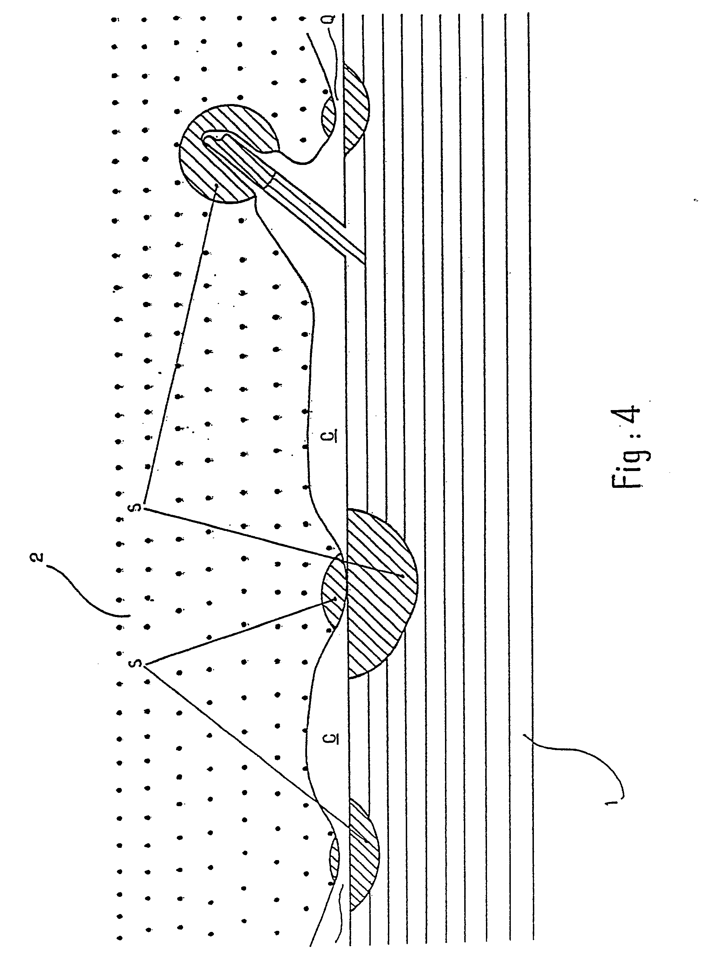

res à propriété de transport quasi unidimensionnel (Q1D) résultaient de l'apparition, le long des chaînes de molécules organiques, de zones supraconductrices limitées, éphémères et fluctuantes, en forme de cigares allongés, de section $d^2$ (d étant la distance entre les empilements de chaînes de molécules organiques) et de longueur $\zeta$ ($\zeta$ étant la longueur de corrélation), et révélant une température critique unidimensionnelle $T_{c1}$ très largement supérieure à la température critique tridimensionnelle $T_{c3}$. Les titulaires ont en effet mis en évidence l'existence d'une bande d'énergie interdite importante au niveau de Fermi par transition d'électrons par effet de tunnel dans une jonction type Schottky entre un composé semi-conducteur dopé 2, en l'espèce GaSb dopé N, déposé en couche mince sur un substrat cristallin d'un composé moléculaire à propriété de transport quasi unidimensionnel ayant une épaisseur de 300 µ. La référence 3 désigne une couche d'étain, 4 étant les électrodes. J.M. Rowell a constaté que l'effet tunnel est le système de détection le plus sensible existant actuellement pour déterminer un état supraconducteur. («Phénomènes d'effet tunnel dans des solides», édité en 1969 par E. Burstein et S. Lundvist, Plenum Press.) Avec le montage représenté sur la fig. 3, on applique un courant de polarisation modulé à basse fréquence, la tension alternative correspondante étant mesurée avec un détecteur synchrone de phase. La résistance dynamique R = dV/dI de la jonction tunnel peut ainsi être déterminée en fonction de la polarisation (maintenue inférieure à 20 mV). On constate, dans ces conditions, l'existence d'un pic plus ou moins marqué dans le diagramme dV/dI − mV autour de la valeur de polarisation nulle, avec une bande interdite $2\Delta$ égale à 3,6 mV ($2\Delta$ étant relié à l'énergie de formation d'une paire d'électrons supraconductrice sur chaque chaîne de molécules).

Comme précédemment évoqué, un monocristal supraconducteur quasi unidimensionnel du type $(TMTSF)_2X$ peut être considéré comme un réseau de chaînes de molécules organiques faiblement couplées, le couplage interchaînes pouvant être assimilé à un très faible couplage du type Josephson. Ce faible couplage est la cause de la basse température critique tridimensionnelle $T_{c3}$ de ces composés (de l'ordre de 1 K). Dans la gamme de températures entre 1 K et 40 K, les propriétés électroniques d'un tel supraconducteur moléculaire organique peuvent être assimilées à un modèle de chaînes supraconductrices quasi unidimensionnelles sensiblement non couplées. Les titulaires se sont donc attachés à tenter d'améliorer le couplage des chaînes, c'est-à-dire à établir des ponts conducteurs entre celles-ci pour figer par réticulation de ces chaînes les conditions de présupraconductivité observées jusqu'à 40 K sous la forme des fluctuations supraconductrices précédemment évoquées.

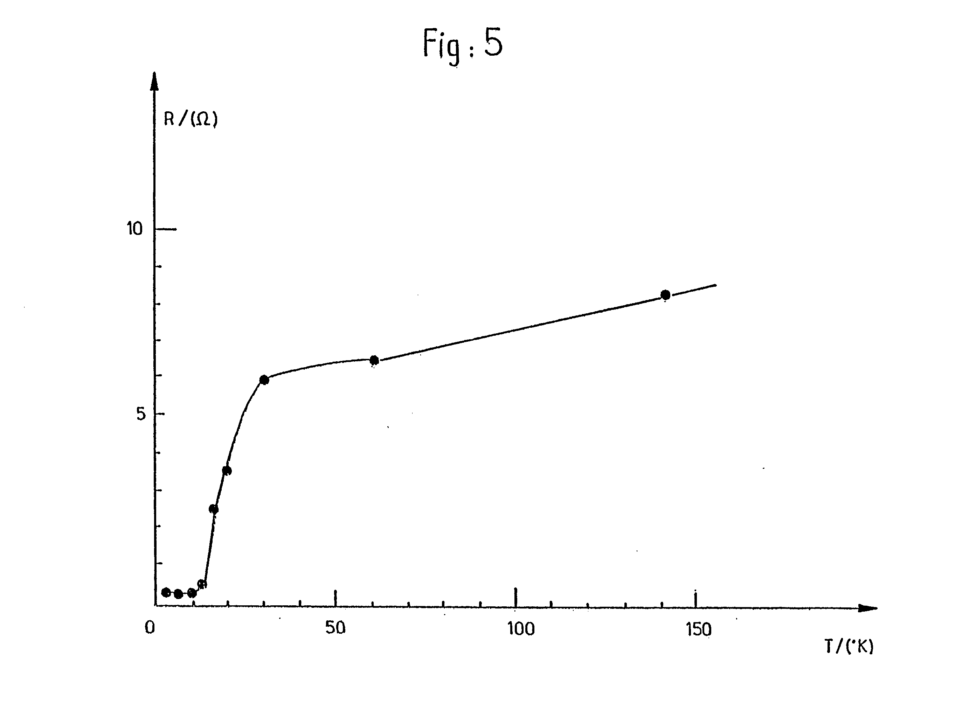

Cette réticulation (ou ce pontage) pour améliorer la force de couplage supraconductrice transversale s'est révélée être atteinte en insérant des atomes étrangers d'un corps potentiellement conducteur métallique ou pseudo-métallique entre les chaînes, ce qui a été effectivement démontré expérimentalement avec le contact de Schottky représenté sur la fig. 4 [contact $(TMTSF)_2$ $Pf_6$/GaSb] et reporté sur la fig. 5. Dans une jonction tunnel de ce type, il existe normalement une interface traditionnelle de barrière (zones C) de 1 à 3 nm d'épaisseur établissant un contact du type conducteur/isolant/supraconducteur (NIS). Toutefois, cette barrière se révèle localement dégradée par la diffusion ou la précipitation d'un excès d'atomes du composé semi-conducteur 2 (en l'espèce des atomes Sb) dans le substrat supraconducteur 1, comme figuré par les zones hachurées S sur la fig. 4. Dans ces zones, les chaînes individuelles de molécules organiques TMTSF deviennent plus fortement couplées du fait des atomes étrangers y inclus, le caractère normalement unidimensionnel de supraconductibilité au-delà de la température critique $T_{c3}$ dans ces zones devenant alors tridimensionnel et impliquant une augmentation de la température critique tridimensionelle $T_{c3}$ au niveau de la température critique unidimensionnelle $T_{c1}$. Les zones stabilisées supraconductrices tridimensionnelles dans le substrat 1 induisent des zones supraconductrices limitées dans le composé semi-conducteur adjacent, par effet de proximité au travers de la faible barrière isolante Schottky. Il s'ensuit que les zones de quasi-contact, telles que Q (jonction supraconducteur/isolant/supraconducteur, SIS), présentent dès lors les caractères de jonction Josephson.

La fig. 5 établit la courbe des variations de la résistance dynamique d'une telle jonction $(TMTSF)_2PF_6$/GaSb sous une pression de 11 kbar. On constate que le contact devient supraconducteur au-dessous de 12 K (la résistance résiduelle de l'ordre de 0,02 $\Omega$ aux très basses températures correspondant aux résistances en série des contacts d'électrode et de la masse du substrat de conducteur moléculaire organique demeurant dans la configuration de supraconduction quasi unidimensionnelle, la résistance devenant véritablement nulle au-dessous du point critique $T_{c3}$.

Les titulaires ont constaté que la bande d'énergie interdite au niveau de Fermi des composés $(TMTSF)_2X$ n'était pas profondément modifiée par la nature de l'anion X, mais qu'en règle générale cette bande interdite $2\Delta$ diminuait lorsque la pression appliquée augmentait. Cette bande interdite constitue donc bien une propriété intrinsèque des chaînes organiques empilées des molécules TMTSF, les expérimentations menées avec $(TMTSF)_2PF_6$ (sous très haute pression) demeurant valables pour les autres familles de composés où X, outre $PF_6$, est $AsF_6$, $TaF_6$, $SbF_6$, $ReO_4$, $NbF_6$ et surtout $ClO_4$, l'anion perchlorate présentant l'énorme avantage de constituer des composés présentant une température critique de supraconduction élevée sous pression ambiante.

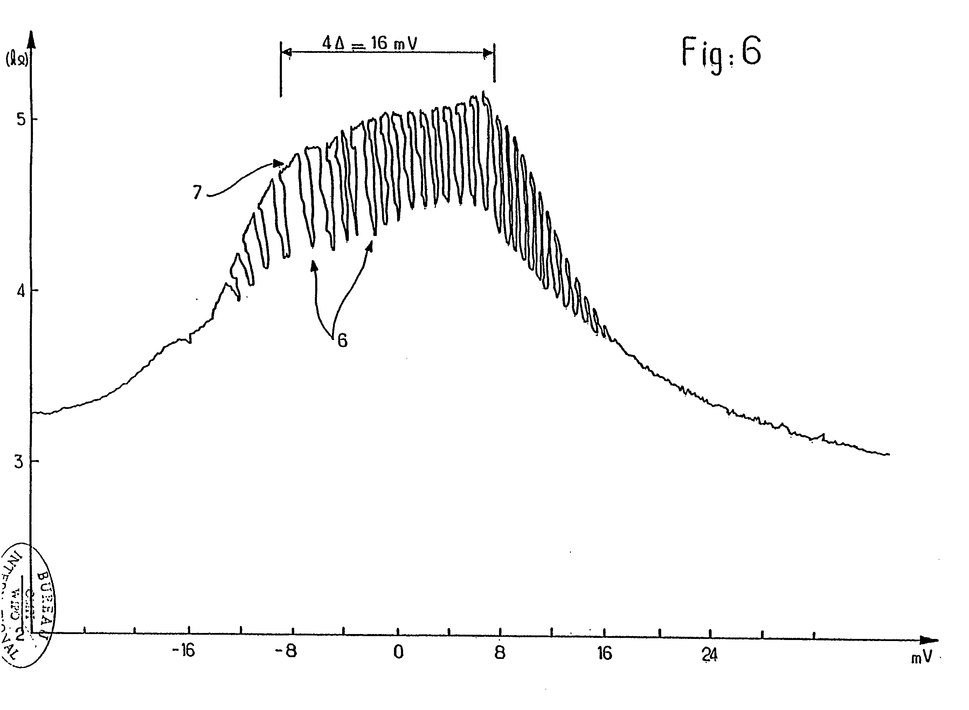

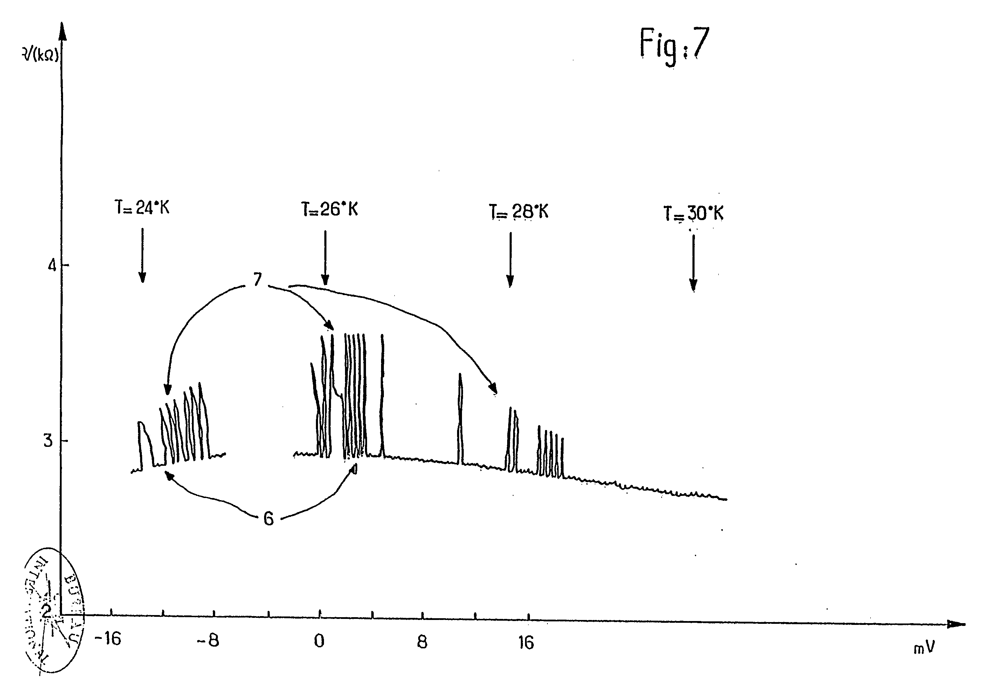

La fig. 6 représente ainsi les variations de résistance dynamique d'un contact Schottky $(TMTSF)_2 ClO_4$/GaSb sous pression ambiante et à 8 K, avec en outre application intermittente d'un rayonnement radiofréquence de 50 MHz (enveloppe inférieure 6 des pics) ou en l'absence de ce rayonnement radiofréquence (enveloppe supérieure 7 des pics). Le rayonnement est constitué d'impulsions de 10 ns avec une période de 20 ns appliquées à une résistance disposée au voisinage de la jonction, mais sans connexion commune entre elles. Le rayonnement radiofréquence influence la résistance différentielle pour les zones de très faible tension sur une plage de tension correspondant à $4\Delta = 16$ mV. Ces modifications, dues à la présence ou à l'absence d'un rayonnement radiofréquence, résultent de l'existence d'un état supraconducteur dans les chaînes organiques du conducteur moléculaire et peuvent être interprétées comme un effet Josephson dans les zones SIS évoquées plus avant. La jonction se comporte donc comme un réseau aléatoire de jonctions Josephson couplées en parallèle, chaque jonction ayant un état supraconducteur ou résistif avec une chute de tension finie. Sur la fig. 6, la courbe correspond à des mesures effectuées à une température de 8 K, la fig. 7 établissant l'absence de telles variations de résistance différentielle en l'absence (7) ou en présence (6) d'une radiofréquence de même fréquence pour une plage de températures allant jusqu'à 30 K. A partir de cette température, l'effet non linéaire Josephson disparaît brutalement.

Il est donc ainsi démontré que, par réticulation ou pontage des chaînes de molécules organiques, c'est-à-dire, au sens de la présente invention, tout contact conducteur de type métallique entre les chaînes instaurant un passage aisé des électrons d'une chaîne à l'autre, on atteint un état supraconducteur tridimensionnel stabilisé jusqu'à 30 K, soit avec une marge de température largement suffisante pour utiliser ces composants dans leur état supraconducteur tridimensionnel avec de l'hydrogène liquide (20 K), ce qui n'était en pratique pas le cas avec les conducteurs intermétalliques supraconducteurs jusqu'à au maximum 23,2 K.

De façon plus générale, on peut donc obtenir une augmentation de la température critique de supraconduction dans les supraconducteurs organiques quasi unidimensionnels du type considéré en réticulant les empilements de chaînes moléculaires par des atomes étrangers d'au moins un corps potentiellement conducteur. Cette inclusion d'atomes étrangers peut s'effectuer aisément par diffusion, par exemple par dépôt par évaporation sous vide, d'atomes étrangers, par exemple d'antimoine, d'arsenic, d'argent, d'or, d'aluminium, de plomb ou d'indium. Les atomes étrangers diffusent ainsi vers l'intérieur du cristal organique entre les chaînes conductrices pour réaliser l'augmentation recherchée du couplage interchaînes.

Les monocristaux de $(TMTSF)_2X$ cristallisent normalement sous forme d'aiguilles rigides et on a pu constater que les mêmes phénomènes d'effet Josephson et d'effets d'une radiofréquence ont été observés sur des jonctions très fines réalisées entre une zone métallique et les extrémités des chaînes organiques. Ce contact métallique d'extrémité assure entre les chaînes initialement individuellement conductrices un couplage suffisant pour induire une transition supraconductrice des chaînes à une température voisine de 30 K, sur une épaisseur $\xi$ de l'ordre de 10 à 100 nm. La nature du métal de contact peut être quelconque (molybdène, niobium, tantale, aluminium, plomb, indium, étain, gallium ou alliages tels que $Nb_3Sn$ ou alliages Nb/Al/Ge). La température critique tridimensionnelle $T_{c3}$ croît initialement avec la concentration d'atomes conducteurs assurant le contact en bout entre chaînes, mais atteint un maximum, de l'ordre de $T_{c1}$, pour une concentration d'atomes conducteurs de l'ordre de 5 à 15%.

Ainsi, suivant cette autre technique, on peut donc envisager d'effectuer un dépôt électrochimique de monocristaux de ces composés sur une électrode, par exemple en argent, sur laquelle ont été préalablement déposés des atomes étrangers à faire diffuser, par exemple par dépôt électrochimique ou par évaporation. Sur ce premier substrat cristallin, d'une épaisseur de l'ordre de 10 à 100 nm, on peut effectuer le dépôt, par exemple par évaporation, d'une autre couche métallique d'atomes étrangers d'une épaisseur de 1 à 5 nm, et ainsi de suite jusqu'à formation de l'autre électrode par dépôt ou contact direct d'or, d'antimoine, d'argent, de GaSb, d'aluminium, de plomb ou d'indium sur le substrat de couches alternées. Les chaînes organiques supraconductrices perpendiculaires aux surfaces des corps potentiellement conducteurs fournisseurs d'atomes étrangers, ou formant un angle important par rapport à celles-ci, voient leur supraconductivité très nettement améliorée par diffusion de ces atomes étrangers de part et d'autre entre les chaînes des substrats adjacents et par le couplage entre extrémités des chaînes par les couches métalliques pour stabiliser le composé cristallin supraconducteur tridimensionnel avec une température critique de l'ordre de 29 K.

Les dispositifs Josephson à base de ces composés peuvent ainsi servir dans toutes les utilisations prévues, en général, pour les dispositifs Josephson, et notamment comme détecteurs ou générateurs dans la zone intermédiaire entre les hyperfréquences et l'infrarouge très lointain (jusqu'à 4000 GHz) où les supraconducteurs usuels métalliques ou intermétalliques ne peuvent plus fonctionner. Les composés supraconducteurs selon l'invention peuvent par ailleurs rester supraconducteurs sous des champs magnétiques très élevés.

## Revendications

1. Procédé d'augmentation de la température critique de supraconduction dans des composés organiques supraconducteurs, caractérisé en ce qu'il comprend l'étape de réticuler les chaînes de molécules organiques d'un substrat de composé cristallin conducteur moléculaire organique à propriété de transport quasi unidimensionnel avec des atomes étrangers d'au moins un corps potentiellement conducteur.

2. Procédé selon la revendication 1, caractérisé en ce que le composé cristallin conducteur moléculaire organique a pour formule $(TMTSF)_2X$ où TMTSF est tétraméthyltétrasélénafulvalen et X est choisi dans le groupe comprenant $ClO_4$, $PF_6$, $TaF_6$, $SbF_6$, $AsF_6$, $ReO_4$.

3. Procédé selon l'une des revendications 1 ou 2, caractérisé en ce que le corps potentiellement conducteur est un semi-conducteur.

4. Procédé selon les revendications 1 ou 2, caractérisé en ce que le corps potentiellement conducteur est un métal.

5. Procédé selon la revendication 4, caractérisé en ce que le corps comprend au moins l'un des métaux choisis parmi le groupe comprenant l'or, l'argent, l'aluminium, le plomb, l'indium, le gallium et le sélénium.

6. Procédé selon l'une des revendications précédentes, caractérisé en ce que la réticulation s'effectue par mise en contact d'extrémités de chaînes adjacents avec une couche du corps potentiellement conducteur.

7. Procédé selon l'une des revendications précédentes, caractérisé en ce que la réticulation s'effectue par diffusion desdits atomes étrangers entre les chaînes organiques.

8. Procédé selon la revendication 7, caractérisé en ce que la diffusion s'effectue par évaporation sous vide.

9. A titre de produit industriel nouveau, composé supraconducteur obtenu par le procédé selon l'une des revendications précédentes.

10. Composé selon la revendication 9, caractérisé en ce que X est $ClO_4$.

11. Composé selon la revendication 10, caractérisé en ce que les atomes étrangers sont des atomes d'antimoine.

## Claims

1. A process for increasing the critical supraconductive temperature in supraconductive organic compounds, comprising the step of cross-linking the organic molecule chains of a substrate including an organic molecular conductive crystal compound having a quasi-unidimensional transport property with extraneous atoms of at least a potentially conductive substance.

2. A process as set forth in Claim 1, wherein said organic molecular conductive crystal compound has the formula $(TMTSF)_2X$, where TMTSF is tetramethyltetraselenafulvalen and X is selected among the group consisting of $ClO_4$, $PF_6$, $TaF_6$, $SbF_6$, $AsF_6$, $ReO_4$.

3. A process as set forth in Claim 1 or 2, wherein said potentially conductive substance is a semi-conductor.

4. A process as set forth in Claim 1 or 2, wherein said potentially conductive substance is a metal.

5. A process as set forth in Claim 4, wherein said substance includes at least one metal selected among the group consisting of gold, silver, aluminium, lead, indium, gallium and selenium.

6. A process as set forth in any preceding claim, wherein said cross-linking is carried out by contacting ends of adjacent chains with a layer of said potentially conductive substance.

7. A process as set forth in any preceding claim, wherein said cross-linking is carried out by diffusing said extraneous atoms between said organic chains.

8. A process as set forth in Claim 1, wherein said diffusion is carried out by a vacuum evaporation process.

9. As a new industrial product, a supraconductive compound obtained by the process according to one of the preceding claims.

10. A compound as set forth in Claim 9, wherein X is $ClO_4$.

11. A compound as set forth in Claim 10, wherein said extraneous atoms are antimony atoms.

## Patentansprüche

1. Verfahren zur Erhöhung der kritischen Supraleitungstemperatur in quasieindimensionaler organischen supraleitenden Verbindungen, dadurch gekennzeichnet, dass es den Schritt aufweist des Vernetzens von Ketten organischer Moleküle eines Substrats einer leitenden kristallinen organischen Molekularverbindung mit quasieindimensionaler Transporteigenschaft, mit fremden Atomen wenigstens eines potentiell leitenden Stoffes.

2. Verfahren nach Anspruch 1, dadurch gekennzeichnet, dass die leitende kristalline organische Molekularverbindung die Formel $(TMTSF)_2X$ besitzt, wobei TMTSF das Tetramethyltetraselenofulvalen ist und X aus der Gruppe ausgewählt ist, die $ClO_4$, $PF_6$, $TaF_6$, $SbF_6$, $AsF_6$ und $ReO_4$ enthält.

3. Verfahren nach einem der Ansprüche 1 oder 2, dadurch gekennzeichnet, dass der potentiell leitende Stoff ein Halbleiter ist.

4. Verfahren nach einem der Ansprüche 1 oder 2, dadurch gekennzeichnet, dass der potentiell leitende Stoff ein Metall ist.

5. Verfahren nach Anspruch 4, dadurch gekennzeichnet, dass der Stoff wenigstens ein Metall aufweist, das aus der Gruppe Gold, Eisen, Aluminium, Blei, Indium, Gallium und Selenium ausgewählt ist.

6. Verfahren nach einem der vorhergehenden Ansprüche, dadurch gekennzeichnet, dass die Vernetzung durch in Kontaktbringen der Enden benachbarter Ketten mit einer Schicht des potentiell leitenden Stoffes erfolgt.

7. Verfahren nach einem der vorhergehenden Ansprüche, dadurch gekennzeichnet, dass die Vernetzung durch Diffusion der genannten fremden Atome in die organischen Ketten erfolgt.

8. Verfahren nach Anspruch 7, dadurch gekennzeichnet, dass die Diffusion durch Verdampfung im Vakuum erfolgt.

9. Neues industrielles Erzeugnis, bestehend aus einem Supraleiter, der gemäss dem Verfahren nach einem der vorhergehenden Ansprüche erhalten ist.

10. Verbindung nach Anspruch 9, dadurch gekennzeichnet, dass das X das $ClO_4$ ist.

11. Verbindung nach Anspruch 10, dadurch gekennzeichnet, dass die fremden Atome die Antimonatome sind.

Fig : 1

A

X

Fig : 2

R(T)/R(300°K)

(I)

$10^{-4}$

(II)

0    10    20    30    40    T (°K)

3    4    2

$l_e$

1

Fig : 3

Fig : 4

0 083 621

Fig : 5

Fig: 6

Fig.7

0 083 621